# EUROPEAN PATENT SPECIFICATION

(11) **EP 3 502 225 B1**
(45) Date of publication and mention of the grant of the patent: **01.09.2021**
(21) Application number: 18215456.7
(22) Date of filing: 21.12.2018
(51) Int. Cl.: C11D 3/04, C11D 3/20, C11D 3/43, C11D 7/10, C11D 7/26, C11D 7/32, C11D 7/50, C11D 11/00, G03F 7/42, C11D 1/62, C11D 3/30, C11D 3/34

(54) **PHOTORESIST STRIPPER**
PHOTOLACKENTFERNER
DÉCAPANT PHOTOSENSIBLE

(30) Priority: 22.12.2017 US 201762609562 P; 17.12.2018 US 201816222248
(43) Date of publication of application: 26.06.2019
(73) Proprietor: Versum Materials US, LLC, Tempe, AZ 85284 (US)
(72) Inventor: Richard, Dalton Peters, Westfield, IN 46074 (US); Phenis, Michael T., Markleville, IN 46056 (US)
(74) Representative: Sommer, Andrea

(56) References cited:
- US-A1- 2004 259 761
- US-A1- 2013 161 840
- US-A1- 2013 334 679
- US-A1- 2014 155 310
- US-A1- 2017 037 344

## Description

### BACKGROUND OF THE INVENTION

The present invention relates generally to compositions having the ability to effectively remove photoresists from substrates, and to methods for using such compositions.

There are many stripper solutions for the removal of photoresists, such as those disclosed in US 7,632,796 B2 and US 2014/0155310 A1. Improved stripper solution compositions are required by wafer manufacturers' increasing demands for improved performance. Strippers need to remain liquid at temperatures below normal room temperature and temperatures frequently encountered in transit and warehousing. Additionally, stripper formulations need to have advantageous loading capacities for the photoresist materials that are removed. Additionally, little or low metal removal (etching) and long stability are desired.

### BRIEF DESCRIPTION OF THE INVENTION

In one aspect of the present invention there are provided photoresist stripper solutions for effectively removing or stripping a photoresist from a substrate. The inventive stripper solutions have particularly high loading capacities for the resist material, and the ability to remain a liquid when subjected to temperatures below normal room temperature that are typically encountered in transit, warehousing and in use in some manufacturing facilities. The compositions have freezing points below 0 °C to minimize solidification during transportation and warehousing.

The compositions according to the present disclosure contain dimethyl sulfoxide (DMSO), a quaternary ammonium hydroxide, an alkanolamine, one or more corrosion inhibitors, and water. The compositions contain from 20% to 90% dimethyl sulfoxide, from 1% to 7% of a quaternary ammonium hydroxide, from 1% to 75% of an alkanolamine having at least two carbon atoms, at least one amino substituent and at least one hydroxyl substituent, the amino and hydroxyl substituents being attached to two different carbon atoms, 0.001 % to 7 % of one or more corrosion inhibitor, and water. The quaternary ammonium hydroxides include choline hydroxide. The quaternary ammonium hydroxides do not include tetramethylammonium hydroxide (TMAH). The resulting compositions additionally exhibit reduced human central nervous system toxicity in comparison to compositions including tetramethylammonium hydroxide (TMAH). Particularly preferred 1,2-alkanolamines include compounds of the formula: 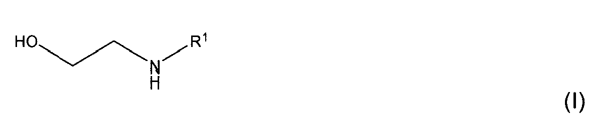 where R¹ can be H, C₁-C₄ alkyl, or C₁-C₄ alkylamino. For particularly preferred alkanol amines of formula I, R¹ is H or CH₂CH₂NH₂. A further embodiment according to this present disclosure contains an additional or secondary solvent. Preferred secondary solvents include glycols and polyhydroxyl compounds.

A second aspect of the present disclosure provides for methods of using the novel stripper solutions described above to remove photoresist and related polymeric materials from a substrate. A photoresist can be removed from a selected substrate having a photoresist thereon by contacting the substrate with a stripping solution for a time sufficient to remove the desired amount of photoresist, by removing the substrate from the stripping solution, rinsing the stripping solution from the substrate with a solvent and drying the substrate.

Other features and advantages of the present invention will be apparent from the following more detailed description, taken in conjunction with the example solutions which illustrate the principles of the invention.

### DETAILED DESCRIPTION OF THE INVENTION

For the purposes of promoting an understanding of what is claimed, references will now be made to the embodiments illustrated and specific language will be used to describe the same. It will nevertheless be understood that no limitation of the scope of what is claimed is thereby intended, such alterations and further modifications and such further applications of the principles thereof as illustrated therein being contemplated as would normally occur to one skilled in the art to which the disclosure relates.

The compositions according to this present disclosure include dimethyl sulfoxide (DMSO), a quaternary ammonium hydroxide, an alkanolamine having at least two carbon atoms, at least one amino substituent and at least one hydroxyl substituent, the amino and hydroxyl substituents being attached to two different carbon atoms, one or more corrosion inhibitors, and water; wherein the compositions exhibit a freezing point below 0 °C. Preferred compositions have freezing points below -5 °C, below -7 °C, below -10 °C, below -12 °C, below -15°C, below -18 °C, and/or below -21 °C and a loading capacity of from 15 cm³/liter up to 90 cm³/liter. Formulations having increased levels of an alkanolamine have the advantage of being particularly noncorrosive to carbon steel and are less injurious to typical waste treatments systems and auxiliary equipment than other stripper solutions. Particularly preferred compositions contain 1,2-alkanolamines having the formula: 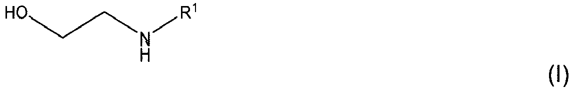 where R¹ is hydrogen, (C₁-C₄) alkyl, or (C₁-C₄) alkylamino. Particularly preferred compositions may contain from 25 wt.% to 75 wt.% of alkanolamine. Some preferred formulations additionally contain a secondary solvent. Particularly preferred formulations may contain from 0.2% to 75% of a secondary solvent. Particularly useful secondary solvents include glycols and polyhydroxyl compounds described in more detail below. Alternatively, in some embodiments, the stripper solutions are free or essentially free of a secondary solvent. Because the preferred stripper solutions remain liquid at low temperatures, the need to liquefy solidified drums of stripper solution received during cold weather or stored in unheated warehouses before the solution can be used is eliminated or minimized. The use of drum heaters to melt solidified stripper solution is time consuming, requires extra handling and can result in incomplete melting and modification of the melted solution's composition.

Additionally, compositions according to the present disclosure display high loading capacities enabling the composition to remove higher levels of photoresists without the precipitation of solids. The loading capacity is defined as the number of cm³ of photoresist or bilayer material that can be removed for each liter of stripper solution before material is redeposited on the wafer or before residue remains on the wafer. For example, if 20 liters of a stripper solution can remove 300 cm³ of photoresist from the surfaces of the wafer before either redeposition occurs or residue remains on the wafer, the loading capacity is 300 cm³/20 liters=15 cm³/liter

The sum of the weight percent of the DMSO and the weight percent of the alkanolamine in the compositions of this invention may be from 55% to 97%. In other embodiments, the compositions may contain from 55% to 95%, or from 65% to 95%, or from 70% to 97% or from 75% to 95%, or from 80% to 97%, or from 85% to 97%, or from 85% to 95%, or from 90% to 97%, or from 75% to 90%, or from 75% to 85%, or from 90% to 95% of DMSO and the alkanolamine. In some embodiments, the weight percent DMSO is greater than the weight percent alkanolamine, and the DMSO may be present in the composition at an amount from 5% to 30%, or from 10% to 30%, or from 10% to 25%, or from 10% to 20% more than the % alkanolamine present. In other compositions, the weight percent DMSO is less than the weight percent alkanolamine, and the DMSO may be present in the composition at an amount from 5% to 30%, or from 10% to 30%, or from 10% to 25%, or from 10% to 20%, or from 15% to 20% less than the % alkanolamine present. Therefore, in some embodiments, the solutions may comprise from 55% to 60%, or from 30% to 50%, or from 35% to 45%, or from 55% to 75% DMSO.

The compositions may comprise from 2% to 6%, or from 2% to about 5%, or from 2% to 4%, or from 2% to 3%, or from 1% to 4% of the quaternary ammonium hydroxide. The quaternary ammonium hydroxide comprises choline hydroxide.

Because some of the stripper solution's components may be provided as aqueous solutions, the composition may additionally contain water. The solutions may contain greater than 1 wt.%, or 2 wt.%, or 3 wt.% water. In other embodiments, the solutions may contain between 1 wt.% or 2 wt.% or 3 wt.% to 7 wt.% or 8 wt.% water. In other embodiments, the solutions may comprise 1 wt.% to 8 wt.% water or wherein a ratio of the amount of the water to the amount of the quaternary ammonium hydroxide is greater than 1.2.

All %'s provided herein are weight percents based on the total weight of the composition.

Suitable levels of the required alkanolamine can range from 1% or 2% to 75% of the composition. In some embodiments, the alkanolamine is from 40% to 65%, or from 50% to 60%, or from 30% to 40% or from 5% to 40% of the solution.

Suitable alkanolamines have at least two carbon atoms and have the amino and hydroxyl substituents on different carbon atoms. Suitable alkanolamines include, but are not limited to, ethanolamine, N-methylethanolamine, N-ethylethanolamine, N-propylethanolamine, N-butylethanolamine, diethanolamine, triethanolamine, N-methyldiethanolamine, N-ethyldiethanolamine, isopropanolamine, diisopropanolamine, triisopropanolamine, N-methylisopropanolamine, N-ethylisopropanolamine, N-propylisopropanolamine, 2-aminopropane-1-ol, N-methyl-2-aminopropane-1-ol, N-ethyl-2-aminopropane-1-ol, 1-aminopropane-3-ol, N-methyl-1-aminopropane-3-ol, N-ethyl-1-aminopropane-3-ol, 1-aminobutane-2-ol, N-methyl-1-aminobutane-2-ol, N-ethyl-1-aminobutane-2-ol, 2-aminobutane-1-ol, N-methyl-2-aminobutane-1-ol, N-ethyl-2-aminobutane-1-ol, 3-aminobutane-1-ol, N-methyl-3-aminobutane-1-ol, N-ethyl-3-aminobutane-1-ol, 1-aminobutane-4-ol, N-methyl-1-aminobutane-4-ol, N-ethyl-1-aminobutane-4-ol, 1-amino-2-methylpropane-2-ol, 2-amino-2-methylpropane-1-ol, 1-aminopentane-4-ol, 2-amino-4-methylpentane-1-ol, 2-aminohexane-1-ol, 3-aminoheptane-4-ol, 1-aminooctane-2-ol, 5-aminooctane-4-ol, 1-aminopropane-2,3-diol, 2-aminopropane-1,3-diol, tris(oxymethyl)aminomethane, 1,2-diaminopropane-3-ol, 1,3-diaminopropane-2-ol, and 2-(2-aminoethoxy)ethanol.

When used, a secondary solvent may comprise from 0.2% to 35%, or from 0.2% to 30%, or from 0.2% to 25%, or from 0.2% to 20%, or from 0.2% to 15%, or from 0.2% to 12%, or from 5% to 12% of the composition. The secondary solvent can include an alcohol, or a polyhydroxyl compound, or a combination of two or more of these.

The secondary solvent alcohols and polyhydroxyl compounds have two or more hydroxyl groups and do not contain ester, amine, or ether groups. The alcohol or polyhydroxyl compounds can be aliphatic, alicyclic, cyclic, or aromatic, but is desirably aliphatic or alicyclic. The alcohol or polyhydroxyl compound can be saturated or unsaturated, and desirably has one or less unsaturated bonds, or no unsaturated bonds. The alcohol and polyhydroxyl compounds desirably do not contain a heteroatom. The alcohol and polyhydroxyl compounds desirably contain only carbon, oxygen, and hydrogen atoms.

As examples of secondary solvent alcohols can be mentioned linear and branched chain and aromatic alcohols. To illustrate an alcohol of the solution can include methanol, ethanol, propanol, isopropyl alcohol, butanol, tert-butyl alcohol, tert-amyl alcohol, 3-methyl-3-pentanol, 1-octanol, 1-decanol, 1-undecanol, 1-dodecanol, 1-tridecanol, 1-tetradecanol, 1-pentadecanol, 1-hexadecanol, 9-hexadecen-1-ol, 1-heptadecanol, 1-octadecanol, 1-nonadecanol, 1-eicosanol, 1-heneicosanol, 1-docosanol, 13-docosen-1-ol, 1-tetracosanol, 1-hexacosanol, 1-heptacosanol, 1-octacosanol, 1-triacontanol, 1-dotriacontanol, 1-tetratriacontanol, cetearyl alcohol, furfurylalcohol, tetrahydrofurfuryl alcohol. In an illustrative example, the solution can include one or more of furfurylalcohol, tetrahydrofurfuryl alcohol, tert-butyl alcohol, or 3-methyl-3-pentanol.

As mentioned above, the secondary solvent can be a polyhydroxyl compound having two or more hydroxyl groups. The polyhydroxyl compound desirably has a molecular weight of no more than 500, or no more than 400, or no more than 350, or no more than 300, or no more than 275, or no more than 250, or no more than 225, or no more than 200, or no more than 175, or no more than 150, or no more than 125, or no more than 100, or no more than 75.

The polyhydroxyl compound as a secondary solvent can include, ethylene glycol; 1,2-propanediol (propylene glycol); 1,3-propanediol, 1,2,3-propanetriol; 1,2-butanediol; 1,3-propanediol; 2,3-butanediol; 1,4-butanediol; 1,2,3-butanetriol; 1,2,4-butanetriol; 1,2-pentanediol; 1,3-pentanediol; 1,4-pentandiol; 2,3-pentanediol; 2,4-pentandiol; 3,4-pentanediol; 1,2,3-pentanetriol; 1,2,4-pentanetriol; 1,2,5-pentanetriol; 1,3,5-pentanetriol; etohexadiol; p-methane-3,8-polyhydroxyl compound; 2-methyl-2,4-pentanediol; 2,2-dimethyl-1,3-propanediol; glycerin; trirnethylolpropane; xylitol; arabitol; 1,2- or 1,3-cyclopentanediol; 1,2- or 1,3-cyclohexanediol; 2,3-norbornanediol; 1,8-octanediol; 1,2-cyclohexane-dimethanol; 1,3-cyclohexanedimethanol; 1,4-cyclohexanedimethanol; 2,2,4-trimethyl-1,3-pentanediol; hydroxypivalyl hydroxypivalate; 2-methyl-1,3-propanediol; 2-butyl-2-ethyl-1,3-propanediol; 2-ethyl-2-isobutyl-1,3-propanediol; 1,6-hexanediol; 2,2,4,4-tetramethyl-1,6-hexanediol; 1,10-decanediol; 1,4-benzenedimethanol; hydrogenated bisphenol A; 1,1,1-trimethylol propane; 1,1,1-trimethylolethane; pentaerythritol; erythritol; threitol; dipentaerythritol; sorbitol; and combinations of 2 or more of the aforementioned polyhydroxyl compounds and polyhydroxyl compound.

In an illustrative example, the solution can include one or more of the secondary polyhydroxyl solvents of ethylene glycol, 1,2-propanediol (propylene glycol), 1,3-propanediol, 1,4-pentanediol, 1,2-butanediol, or 1,3-butanediol.

The compositions contains one or more corrosion inhibitors. Suitable corrosion inhibitors include, but are not limited to, aromatic hydroxyl compounds such as catechol and resorcinol; alkylcatechols such as methylcatechol, ethylcatechol and t-butylcatechol, phenols and pyrogallol; aromatic triazoles such as benzotriazole; alkylbenzotriazoles; sugar alcohols such as glycerol and sorbitol; carboxylic acids such as formic acid, acetic acid, propionic acid, butyric acid, isobutyric acid, oxalic acid, malonic acid, succinic acid, glutaric acid, maleic acid, fumaric acid, benzoic acid, phtahlic acid, 1,2,3-benzenetricarboxylic acid, glycolic acid, lactic acid, malic acid, citric acid, acetic anhydride, phthalic anhydride, maleic anhydride, succinic anhydride, salicylic acid, gallic acid, and gallic acid esters such as methyl gallate and propyl gallate; metal salts such as copper (II) nitrate; copper (II) bromide; copper (II) chlorate; copper (II) chloride; copper (II) fluorosilicate; copper (II) formate; copper (II) selenate; copper (II) sulfate; organic salts of carboxyl containing organic containing compounds described above, basic substances such as ethanolamine, trimethylamine, diethylamine and pyridines, such as 2-aminopyridine, and chelate compounds such as phosphoric acid-based chelate compounds including 1,2-propanediaminetetramethylene phosphonic acid and hydroxyethane phosphonic acid, carboxylic acid-based chelate compounds such as ethylenediaminetetraacetic acid and its sodium and ammonium salts, dihydroxyethylglycine and nitrilotriacetic acid, amine-based chelate compounds such as bipyridine, tetraphenylporphyrin and phenanthroline, and oxime-based chelate compounds such as dimethylglyoxime and diphenylglyoxime. A single corrosion inhibitor may be used or a combination of corrosion inhibitors may be used. In an embodiment, the solution may contain 0.05 weight percent to 7 weight percent of a first corrosion inhibitor and 0.001 weight percent to 3 weight percent of a second corrosion inhibitor. In other embodiments, the solution may contain at least 0.05 weight percent, or at least 0.1 weight percent, or at least 1 weight percent, and/or less than 3 weight percent, and/or less than 7 weight percent of the first corrosion inhibitor. In other embodiments, the solution may contain at least 0.001 weight percent, or at least 0.01 weight percent, or at least 0.1 weight percent, and/or less than 1 weight percent, and/or less than 2 weight percent, and/or less than 3 weight percent of the second corrosion inhibitor. The first and second corrosion inhibitors are not the same. Both the first corrosion inhibitor and the second corrosion inhibitor may be selected from the corrosion inhibitors described above. In one embodiment, the one or more corrosion inhibitors may comprise copper (II) nitrate; copper (II) bromide; copper (II) chlorate; copper (II) chloride; copper (II) fluorosilicate; copper (II) formate; copper (II) selenate; and/or copper (II) sulfate alone or in combination with at least one of the corrosion inhibitors above. In an alternative embodiment, the one or more corrosion inhibitors may be copper (II) nitrate, copper (II) bromide; copper (II) chlorate; copper (II) chloride; copper (II) fluorosilicate; copper (II) formate; copper (II) selenate; copper (II) sulfate and/or resorcinol. In another preferred embodiment the corrosion inhibitor may comprise copper (II) nitrate and resorcinol.

The stripping formulations can also contain an optional one ore more surfactants, typically at levels in the range of 0.01% to 3% or from 0.01 to 1 wt.%. Preferred optional surfactants include fluorosurfactants. One example of a preferred fluorosurfactant is DuPont FSO (fluorinated telomere B monoether with polyethylene glycol (50%), ethylene glycol (25%), 1,4-dioxane (<0.1%), water 25%). Another example of a preferred fluorosurfactant is DuPont, Capstone, FS-10, (30% perfluoroalkylsulfonic acid in water).

Preferred temperatures of at least 50 °C are preferred for contacting the substrate whereas for a majority of applications, temperatures of from 50 °C to 75 °C are more preferred. For particular applications where the substrate is either sensitive or longer removal times are required, lower contacting temperatures are appropriate. For example, when reworking substrates, it may be appropriate to maintain the stripper solution at a temperature of at least 20 °C for a longer time to remove the photoresist and avoid damaging to the substrate.

When immersing a substrate, agitation of the composition additionally facilitates photoresist removal. Agitation can be effected by mechanical stirring, circulating, or by bubbling an inert gas through the composition. Upon removal of the desired amount of photoresist, the substrate is removed from contact with the stripper solution and rinsed with water or an alcohol. DI water is a preferred form of water and isopropanol is a preferred alcohol. For substrates having components subject to oxidation, rinsing is preferably done under an inert atmosphere. The preferred stripper solutions according to the present disclosure have improved loading capacities for photoresist materials compared to current commercial products and are able to process a larger number of substrates with a given volume of stripper solution.

The stripper solutions provided in this disclosure can be used to remove polymeric resist materials present in a single layer or certain types of bilayer resists. For example, bilayer resists typically have either a first inorganic layer covered by a second polymeric layer or can have two polymeric layers. Utilizing the methods taught below, a single layer of polymeric resist can be effectively removed from a standard wafer having a single polymer layer. The same methods can also be used to remove a single polymer layer from a wafer having a bilayer composed of a first inorganic layer and a second or outer polymer layer. Finally, two polymer layers can be effectively removed from a wafer having a bilayer composed of two polymeric layers.

This disclosure describes chemical solutions used for removal of thick photoresist, which may be a resist of from 10 µm to 200 µm or more, or 15 µm to 200 µm, or from 20 µm to 200 µm in advanced packaging applications for semiconductor devices. In other cases, the chemical solutions may be used to remove photoresist from 1 µm to 200 µm or more, or 2 µm to 200 µm, or from 3 µm to 200 µm. In one embodiment, the solutions described contain DMSO, monoethanol amine (MEA), water, quaternary ammonium hydroxide, and at least one corrosion inhibitor. The quaternary ammonium hydroxide and the stripper solutions of this invention are essentially free of TMAH. The quaternary ammonium hydroxide is preferentially either choline hydroxide or dimethyldipropylammonium hydroxide. By essentially free it is meant an amount less than 1 percent, alternately less than 0.1 percent, alternately less than 0.01 percent or less than 0.001 percent. Essentially free of also includes free of which is no TMAH is present. In a further embodiment, the quaternary ammonium hydroxide is free of TMAH. The solutions also optionally contain a surfactant. The solutions may contain greater than 1 or 3 wt.% water. In an embodiment, the solutions may contain between 1 wt.% or 2 wt.% or 3 wt.% to 7 wt.% or 8 wt.% water. In another embodiment, a ratio of the amount of water to the amount of quaternary ammonium hydroxide in the solutions is greater than 1.2, greater than 1.5, greater than 1.8, greater than 2.0, greater than 2.2, and/or greater than 2.5. In an alternative embodiment, the ratio of the amount of water to the amount of quaternary ammonium hydroxide in the solutions is from 1.2 to 1.5. The solutions may also contain greater than 25 wt.% MEA.

Some embodiments of the compositions of the invention may be essentially free of, alternatively free of (as those terms were defined earlier) one or more than one of the following in any combination: nitrogen containing solvents, bis-choline salts, tri-choline salts, oxoammonium compounds, hydroxylamines and derivatives thereof, methyldiethanolamines, aminoethylethanolamines, glycol ethers, hydrogen peroxide, oxidants, organic acids, inorganic acids, inorganic bases, metal hydroxides, glycols, polyols, NMP, surfactants, metal-containing compounds, sugar alcohols and aromatic hydroxyl compounds, and combinations of any of the them. In other embodiments, the composition will be essentially free of (or free of) sodium, and/or calcium, and/or amino carboxylic acids, and/or alcohols, and/or ethylene diamine, and/or ethylene triamine, and/or thiophenol. In some embodiments, the compositions disclosed herein are formulated to be essentially free or free of at least one of the following chemical compounds: alkyl thiols, and organic silanes. In some embodiments, the compositions disclosed herein are formulated to be essentially free or free of one or more of the following: halide-containing compound, for example it may be essentially free or free of one or more of the following: fluoride-, bromine-, chlorine- or iodine-containing compounds. In other embodiments, the composition may be essentially free or free of sulfonic acid and/or phosphoric acid and/or sulfuric acid and/or nitric acid and/or hydrochloric acid. In other embodiments, the composition may be essentially free or free of sulfates and/or nitrates and/or sulfites and/or nitrites. In other embodiments, the composition may be essentially free or free of: ethyl diamine, sodium-containing compounds and/or calcium-containing compounds and/or manganese-containing compounds or magnesium-containing compounds and/or chromium-containing compounds and/or sulfur-containing compounds and/or silane-containing compounds and/or phosphorus-containing compounds. Some embodiments may be essentially free of or free of surfactants. Some embodiments may be essentially free or free of amphoteric salts, and/or cationic surfactants, and/or anionic surfactants, and/or zwitterionic surfactants, and/or non-ionic surfactants. Some embodiments may be essentially free of or free of imidizoles, and/or anhydrides. Some embodiments may be essentially free of or free of pyrrolidones, and/or acetamides. Some embodiments may be essentially free or free of any amines. Some embodiments may be essentially free of or free of peroxy-compounds, and/or peroxides, and/or persulfates, and/or percarbonates, and acids thereof, and salts thereof. Some embodiments may be essentially free of or free of iodates, and/or perboric acid, and/or borates, and/or percarbonates, and/or peroxyacids, and/or cerium compounds, and/or cyanides, and/or periodic acid and/or ammonium molybdate, and/or ammonia. The components that the compositions of this invention may be free of may be in any combination of components as if all of the combinations were set forth herein.

The composition of the present invention may also include one or more of the following additives: chelating agents, chemical modifiers, dyes, biocides, and other additives. The additive(s) may be added to the extent that they do not adversely affect the performance of the composition, typically in amounts up to a total of 5 weight % of the composition. In other embodiments the composition will be essentially free of or free of chelating agents, dyes, biocides and/or other additives.

Particularly preferred compositions of the present invention comprise: 55 wt.% to 60 wt.% of dimethyl sulfoxide; 1.5 wt.% to 3.5 wt.% of quaternary ammonium hydroxide; 30 wt.% to 40 wt.% of alkanolamine; and 0.001 wt.% to 3 wt.% of the first corrosion inhibitor.

Other particularly preferred compositions of the present invention comprise: 35 wt.% to 45 wt.% of dimethyl sulfoxide; 1.5 wt.% to 3.5 wt.% of quaternary ammonium hydroxide; 50 wt.% to 60 wt.% of alkanolamine; 0.05 wt.% to 3 wt.% of the first corrosion inhibitor; and 0.001 wt.% to 0.1 wt.% of the second corrosion inhibitor.

In the Example 1, various stripping compositions were used to remove thick spin-on photoresist from a silicon wafer plated with Cu pillars and Sn/Ag solder caps. Resist removal was performed using an immersion process in a beaker.

For the immersion process, coupon-sized samples of semiconductor wafers were processed in beakers. Beakers were filled with 100 mL of a stripping composition and heated to the target temperature of 70 °C. When the stripping composition was at the target temperature, a coupon was placed in a holder in the beaker, and slight agitation was provided by a stir bar. Temperature was maintained at the target temperature of 70 °C throughout the process. After a total processing time of 60 minutes, the coupons were removed from the beaker, rinsed with DI water and IPA, and dried with a stream of air.

For the experiments described below, resist removal was observed and noted accordingly. Resist removal is defined as "clean" if all resist was removed from the wafer coupon surface; as "mostly clean" if at least 95% of the resist, but not all of the resist, was removed from the surface; and "partly clean" if at least 80% of the resist, but less than 95% of the resist, was removed from the surface.

The follow abbreviations are used in the various compositions listed below: DMSO = dimethyl sulfoxide; MEA = monoethanolamine; MMB = 3-methoxy 3-methyl-1-butanol; TMAH = tetramethylammonium hydroxide; PG = propylene glycol; DMDPAH = dimethyldipropylammonium hydroxide; THFA = tetrahydrofurfuryl alcohol; DB = diethylene glycol monobutyl ether; CH = choline hydroxide; FS-10 = fluorosurfactant (30% perfluoroalkylsulfonic acid in water).

Table 1 lists various inventive and comparative stripping compositions.

### Example 1

Table 2 lists stripping compositions that were tested for Example 1 using the immersion process and semiconductor wafers with thick photoresist with plated Cu pillars and Sn/Ag solder caps. The heating temperature and time for all compositions in Table 2 was 70 °C and 60 minutes, respectively.

In the Example 2, various stripping compositions were used to remove 40µm thick negative dry film photoresist from a silicon wafer plated with Cu features. Resist removal was performed using an immersion process in a beaker.

For the immersion process, coupon-sized samples of semiconductor wafers were processed in beakers. Beakers were filled with 100 mL of a stripping composition and heated to the target temperature of 70 °C. When the stripping composition was at the target temperature, a coupon was placed in a holder in the beaker, and slight agitation was provided by a stir bar. Temperature was maintained at the target temperature of 70 °C throughout the process. After a total processing time of 30-60 minutes, the coupons were removed from the beaker, rinsed with DI water and IPA, and dried with a stream of air.

For the experiments described below, resist removal was observed and noted accordingly. Resist removal is defined as "clean" if all resist was removed from the wafer coupon surface; as "mostly clean" if at least 95% of the resist, but not all of the resist, was removed from the surface; and "partly clean" if at least 80% of the resist, but less than 95% of the resist, was removed from the surface.

### Example 2

Table 3 lists stripping compositions that were tested for Example 2 using the immersion process and semiconductor wafers with thick dry film photoresist with plated Cu features. The heating temperature in Table 3 was 70 °C.

### Example 3

In the Example 3, various stripping compositions were used to evaluate metal corrosion. A metal corrosion test was performed using an immersion process in a beaker.

For the immersion process, coupon-sized samples of semiconductor wafers containing a known thickness layer of Cu and coupon-sized samples of semiconductor wafers containing a known thickness layer of Sn were processed in beakers. The Cu and Sn thickness layers were deposited on the wafers by physical vapor deposition. Beakers were filled with 100 mL of a stripping composition and heated to the target temperature of 70 °C. When the stripping composition was at the target temperature, a sample coupon having each metal thereon and having a known surface area was placed in a holder in the beaker, and agitation was provided by a stir bar. Temperature was maintained at the target temperature of 70 °C throughout the process. After a total processing time of 60 or 120 minutes, the coupons were removed from the beakers.

Samples of the solution were collected, and concentrations of dissolved Cu and Sn were measured by inductively coupled plasma atomic emission spectroscopy (ICP-AES). Concentrations of dissolved Cu and Sn were also measured in samples of the solutions taken as controls before the solutions were heated and used to process coupons. The change in the concentration of dissolved Cu or Sn indicated the amount of metal that was dissolved by the formulation during the coupon cleaning process. A small change in dissolved metal concentrations of ≤10 ppm vs. the control level indicates very good metal compatibility, that is, a low metal etch rate.

Table 4 lists ICP-AES measurements for Example 3 for dissolved Cu and Sn concentrations using the immersion process. The control amounts for Cu and Sn are listed respectively in columns 3 and 4 of Table 4, the measured amounts are listed in the next 4 columns as labeled. Concentrations of ≤10 ppm vs. the control are preferred with a target of 0 ppm. The heating temperature all compositions in Table 4 was 70 °C and the processing times were 60 minutes and 120 minutes, respectively. The amount of Cu or Sn dissolved by the stripper solutions (removed from the wafer coupon) can be determined by subtracting the control amount from the measured amount. For example, for Formulation 1: 2 ppm (2 ppm minus 0 ppm) of Cu was dissolved by the stripper solution at 70°C and 60 minutes; and 3.8 ppm (4.3 ppm minus 0.5 ppm) of Sn was dissolved by the stripper solution at 70°C and 60 minutes.

Table 5 lists the freezing point of various formulations with lower temperatures being preferred for improved storage and transportation capabilities.

### Example 4

In the Example 4, tests were performed to evaluate the stability of the quaternary ammonium hydroxides. Stability was tested by heating 100ml of the formulations in a beaker to a target temperature of 70°C. The target temperature was maintained for 8 hours. Small samples were removed from the beakers at target intervals of 2 hours and tested by acid-base titration.

Table 6 lists the change in wt% base levels measured by acid-base titration at each target interval up to 8 hours. A smaller wt% rate of change per target interval is preferred and indicates a more stable formulation. Improved formulation stability provides the user with a longer product shelf life storage, longer product bath life during use and improved photoresist loading capabilities. The change in wt% base from time 0 through 8 hours is reported in the last row of the table and indicates that Formulation 10 had the smallest change.

**Table 1**

| Formulation 1 | Formulation 2 | Formulation 3 | Comparative Formulation 1 |
|---|---|---|---|
| 38.99% DMSO | 80.89% THFA | 56.99% DMSO | 69.075% DB solvent |
| 55.0% MEA | 6% MEA | 36% MEA | 20% MEA |
| 2.475% CH | 2.62% DMDPAH | 2.6% DMDPAH | 2.475% TMAH |
| 3.025% water | 10.48% PG | 3.9% water | 7.44% water |
| 0.5% sorbitol | 0.01% FS-10 | 0.5% sorbitol | 1 % sorbitol |
| 0.01% FS-10 | | 0.01% FS-10 | 0.010% copper (II) nitrate hemi(pentahydrate) |
| | | | |

| Comparative Formulation 2 | Comparative Formulation 3 | Comparative Formulation 4 | Formulation 4 |
|---|---|---|---|
| 54.090% THFA | 54.09% DB solvent | 58.34% DB solvent | 43.99% DMSO |
| 36% MEA | 36% MEA | 36% MEA | 36% MEA |
| 2.475% TMAH | 2.475% TMAH | 2.45% TMAH | 4% DMDPAH |
| 7.425% water | 7.425% water | 2.45% water | 16% PG |
| 0.01% FS-10 | 0.01% FS-10 | 0.01% FS-10 | 0.01% FS-10 |
| | | 0.75% sorbitol | |
| | | | |

| Formulation 5 | Formulation 6 | Formulation 7 | |
|---|---|---|---|
| 53.49% DMSO | 34.49% DMSO | 37.99% DMSO | |
| 36% MEA | 55% MEA | 55% MEA | |
| 4% DMDPAH | 4% DMDPAH | 2.6% DMDPAH | |
| 6% water | 6% water | 3.9% water | |
| 0.01% FS-10 | 0.01% FS-10 | 0.01% FS-10 | |
| 0.5% sorbitol | 0.5% sorbitol | 0.5% sorbitol | |
| | | | |

| Formulation 8 | Comparative Formulation 5 | Comparative Formulation 6 | |
|---|---|---|---|
| 80.865% DMSO | 81.9% DMSO | 59.22% DMSO | |
| 6% MEA | 3% MEA | 35.92% MEA | |
| 2.62% DMDPAH | 2.55% TMAH | 2.425% TMAH | |
| 10.48% PG | 2.55% water | 2.425% water | |
| 0.010% copper (II) nitrate hemi(pentahydrate) | 10% MMB | 0.01% FS-10 | |
| 0.01% FS-10 | | | |
| | | | |

| Formulation 9 | Formulation 10 | Formulation 11 | |
|---|---|---|---|
| 38.475% DMSO | 38.975% DMSO | 39.0% DMSO | |
| 55.0% MEA | 55.0% MEA | 55.0% MEA | |
| 2.475% CH | 2.475% CH | 2.475% CH | |
| 3.04% water | 3.04% water | 3.025% water | |
| 1% sorbitol | 0.5% resorcinol | 0.5% resorcinol | |
| 0.010% copper (II) nitrate hemi(pentahydrate) | 0.010% copper (II) nitrate hemi(pentahydrate) | | |

**Table 2**

| **Formulation** | **Resist removal** |
|---|---|
| Formulation 2 | Partly clean |
| Formulation 3 | Partly clean |
| Comparative Formulation 1 | Partly clean |
| Comparative Formulation 2 | Mostly clean |
| Comparative Formulation 3 | Partly clean |
| Comparative Formulation 4 | Partly clean |
| Formulation 4 | Mostly clean |
| Formulation 5 | Mostly clean |
| Formulation 6 | Mostly clean |
| Formulation 7 | Mostly clean |
| Formulation 10 | Clean |

**Table 3**

| **Formulation** | **Process Time** | **Resist Removal** |
|---|---|---|
| Formulation 8 | 60 min | Clean |
| Comparative Formulation 5 | 60 min | Clean |
| Comparative Formulation 6 | 60 min | Clean |
| Formulation 3 | 30 min | Clean |

**Table 4**

| Formulation | Control | | 70°C/60 min | | 70°C/120 min | |
|---|---|---|---|---|---|---|
| | Cu (ppm) | Sn (ppm) | Cu (ppm) | Sn (ppm) | Cu (ppm) | Sn (ppm) |
| Formulation 1 | 0 | 0.5 | 2.0 | 4.3 | 3.3 | 7.4 |
| Formulation 9 | 32.1 | 0.5 | 32 | 0.7 | 33.6 | 0.8 |
| Formulation 10 | 32.2 | 0.5 | 32.2 | 0.6 | 32 | 0.7 |
| Formulation 11 | 0 | 0.5 | 13.7 | 0.8 | 18.7 | 0.8 |

**Table 5**

| Formulation | Freezing point (°C) |
|---|---|
| Formulation 1 | < -21 |
| Formulation 3 | < -21 |
| Formulation 8 | 8 |
| Formulation 10 | < -21 |
| Comparative Formulation 5 | 10 |

**Measured Weight Percent Base Over Time**

| hours @ 70°C | Formulation 2 | Comparative formulation 5 | Formulation 10 |
|---|---|---|---|
| 0 | 2.45 | 2.59 | 2.51 |
| 2 | 2.31 | 2.40 | 2.43 |
| 4 | 2.13 | 2.13 | 2.36 |
| 6 | 1.97 | 1.98 | 2.26 |
| 8 | 1.88 | 1.71 | 2.16 |
| Change in wt% over 8 hours | 0.57 | 0.88 | 0.35 |

Formulations 2 to 8 are comparative.

While the invention has been described with reference to one or more embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified. Further, any use of "having", "comprising" or "containing" in the specification and in the claims include the more narrow descriptors: "consisting essentially of" and "consisting of" as if they were expressly written in the alternative following "having", "comprising" or "containing". Additionally, the use of the articles "a" or "an" or "the" to describe any of the components of the stripper compositions shall be interpreted anywhere that they appear in the specifications and the claims as if they were replaced with "one or more than one".

## Claims

1. A stripper solution for removing photoresist from substrates comprising:
20 wt.% to 90 wt.% dimethyl sulfoxide;
1 wt.% to 7 wt.% of quaternary ammonium hydroxide;
1 wt.% to 75 wt.% of alkanolamine;
0.001 wt.% to 7 wt.% of one or more corrosion inhibitors; and
water;
wherein the solution exhibits a freezing point below 0 degrees Celsius;
wherein the alkanolamine has at least two carbon atoms, at least one amino substituent and at least one hydroxyl substituent, the amino and hydroxyl substituents being attached to two different carbon atoms,
and
wherein the quaternary ammonium hydroxide is essentially free of tetramethylammonium hydroxide and includes choline hydroxide.

2. The solution of claim 1, comprising 1 wt.% to 8 wt.% water or wherein a ratio of the amount of the water to the amount of the quaternary ammonium hydroxide is greater than 1.2.

3. The solution of the preceding claims, wherein the alkanolamine is present in the amount of 25 wt.% to 75 wt.%.

4. The solution of the preceding claims, wherein the alkanolamine includes monoethanolamine.

5. The solution of the preceding claims,
wherein the dimethyl sulfoxide is present in the amount of 55 wt.% to 60 wt.%; wherein the quaternary ammonium hydroxide is present in the amount of 1.5 wt.% to 3.5 wt.%;
wherein the alkanolamine is present in the amount of 30 wt.% to 40 wt.%; and wherein the corrosion inhibitors are present in the amount of 0.001 wt.% to 3 wt.%.

6. The solution of the preceding claims, wherein a first corrosion inhibitor is selected from the group consisting of resorcinol, glycerol, sorbitol, and copper (II) nitrate.

7. The solution of the preceding claims 1 to 5, wherein a first corrosion inhibitor is selected from the group consisting of copper (II) nitrate; copper (II) bromide; copper (II) chlorate; copper (II) chloride; copper (II) fluorosilicate; copper (II) formate; copper (II) selenate; and/or copper (II) sulfate and resorcinol.

8. The solution of the preceding claims, wherein a first corrosion inhibitor is present in an amount between 0.001 wt.% to 0.1 wt.%.

9. The solution of the preceding claims, further comprising 0.01 wt.% to 3 wt.% of surfactant.

10. The solution of claims 6 to 8, comprising a second corrosion inhibitor, wherein the second corrosion inhibitor is different from the first corrosion inhibitor and is selected from the group consisting of resorcinol, glycerol, sorbitol, and copper (II) nitrate.

11. The solution of the preceding claims 1 to 4, wherein the dimethyl sulfoxide is present in the amount of 35 wt.% to 45 wt.%, the quaternary ammonium hydroxide is present in the amount of 1.5 wt.% to 3.5 wt.%, the alkanolamine is present in the amount of 50 wt.% to 60 wt.%, a first corrosion inhibitor is present in the amount of 0.05 wt.% to 3 wt.%, and a second corrosion inhibitor in the amount of 0.001 wt.% to 0.1 wt.%.

12. The solution of claim 11, wherein a first corrosion inhibitor is selected from the group consisting of copper (II) nitrate; copper (II) bromide; copper (II) chlorate; copper (II) chloride; copper (II) fluorosilicate; copper (II) formate; copper (II) selenate; and/or copper (II) sulfate and resorcinol.

13. The solution of any of claim 11 or 12, comprising a second corrosion inhibitor, wherein the second corrosion inhibitor is different from the first corrosion inhibitor and is selected from the group consisting of resorcinol, glycerol, sorbitol, and copper (II) nitrate.

14. The solution of the preceding claims, wherein the freezing point is below -15 degrees Celsius or below -21 degrees Celsius.

15. A method of cleaning resist from a substrate comprising:
contacting the resist on a substrate with a stripping solution for a time sufficient to remove the desired amount of resist and removing the substrate from the stripping solution wherein the stripping solution comprises:
20 wt.% to 90 wt.% dimethyl sulfoxide;
1 wt.% to 7 wt.% of quaternary ammonium hydroxide;
1 wt.% to 75 wt.% of alkanolamine;
0.001 wt.% to 7 wt.% of one or more corrosion inhibitors; and
1 wt.% to 8 wt.% water;
wherein the solution exhibits a freezing point below 0 degrees Celsius;
wherein the alkanolamine has at least two carbon atoms, at least one amino substituent and at least one hydroxyl substituent, the amino and hydroxyl substituents being attached to two different carbon atoms;
and
wherein the quaternary ammonium hydroxide is essentially free of tetramethylammonium hydroxide and includes choline hydroxide.

## Patentansprüche

1. Entfernerlösung zum Entfernen von Photolack von Substraten umfassend:
20 Gew.-% bis 90 Gew.-% Dimethylsulfoxid;
1 Gew.-% bis 7 Gew.-% quartäres Ammoniumhydroxid;
1 Gew.-% bis 75 Gew.-% Alkanolamin;
0,001 Gew.-% bis 7 Gew.-% von einem oder mehreren Korrosionsinhibitoren; und
Wasser;
wobei die Lösung einen Gefrierpunkt von unter 0 Grad Celsius aufweist;
wobei das Alkanolamin mindestens zwei Kohlenstoffatome, mindestens einen Aminosubstituenten und mindestens einen Hydroxylsubstituenten aufweist, wobei die Amino- und Hydroxylsubstituenten an zwei unterschiedlichen Kohlenstoffatomen gebunden sind,
und
wobei das quartäre Ammoniumhydroxid im Wesentlichen frei von Tetramethylammoniumhydroxid ist und Cholinhydroxid einschließt.

2. Lösung nach Anspruch 1, umfassend 1 Gew.-% bis 8 Gew.-% Wasser oder wobei ein Verhältnis der Menge des Wassers zur Menge des quartären Ammoniumhydroxids größer als 1,2 ist.

3. Lösung nach den vorhergehenden Ansprüchen, wobei das Alkanolamin in der Menge von 25 Gew.-% bis 75 Gew.-% vorhanden ist.

4. Lösung nach den vorhergehenden Ansprüchen, wobei das Alkanolamin Monoethanolamin einschließt.

5. Lösung nach den vorhergehenden Ansprüchen,
wobei das Dimethylsulfoxid in der Menge von 55 Gew.-% bis 60 Gew.-% vorhanden ist;
wobei das quartäre Ammoniumhydroxid in der Menge von 1,5 Gew.-% bis 3,5 Gew.-% vorhanden ist;
wobei das Alkanolamin in der Menge von 30 Gew.-% bis 40 Gew.-% vorhanden ist; und
wobei die Korrosionsinhibitoren in der Menge von 0,001 Gew.-% bis 3 Gew.-% vorhanden sind.

6. Lösung nach den vorhergehenden Ansprüchen, wobei ein erster Korrosionsinhibitor aus der Gruppe, bestehend aus Resorcin, Glycerol, Sorbitol und Kupfer (II)-nitrat, ausgewählt ist.

7. Lösung nach den vorhergehenden Ansprüchen 1 bis 5, wobei ein erster Korrosionsinhibitor aus der Gruppe, bestehend aus Kupfer (II)-nitrat; Kupfer (II)-bromid; Kupfer (II)-chlorat; Kupfer (II)-chlorid; Kupfer (II)-fluorosilicat; Kupfer (II)-formiat; Kupfer (II)-selenat; und/oder Kupfer (II)-sulfat und Resorcin, ausgewählt ist.

8. Lösung nach den vorhergehenden Ansprüchen, wobei ein erster Korrosionsinhibitor in einer Menge zwischen 0,001 Gew.-% bis 0,1 Gew.-% vorhanden ist.

9. Lösung nach den vorhergehenden Ansprüchen, ferner umfassend 0,01 Gew.-% bis 3 Gew.-% an grenzflächenaktivem Mittel.

10. Lösung nach den Ansprüchen 6 bis 8, umfassend einen zweiten Korrosionsinhibitor, wobei der zweite Korrosionsinhibitor von dem ersten Korrosionsinhibitor unterschiedlich ist und aus der Gruppe, bestehend aus Resorcin, Glycerol, Sorbitol und Kupfer (II)-nitrat, ausgewählt ist.

11. Lösung nach den vorhergehenden Ansprüchen 1 bis 4, wobei das Dimethylsulfoxid in der Menge von 35 Gew.-% bis 45 Gew.-% vorhanden ist, das quartäre Ammoniumhydroxid in der Menge von 1,5 Gew.-% bis 3,5 Gew.-% vorhanden ist, das Alkanolamin in der Menge von 50 Gew.-% bis 60 Gew.-% vorhanden ist, ein erster Korrosionsinhibitor in der Menge von 0,05 Gew.-% bis 3 Gew.-% vorhanden ist und ein zweiter Korrosionsinhibitor in der Menge von 0,001 Gew.-% bis 0,1 Gew.-% vorhanden ist.

12. Lösung nach Anspruch 11, wobei ein erster Korrosionsinhibitor aus der Gruppe, bestehend aus Kupfer (II)-nitrat; Kupfer (II)-bromid; Kupfer (II)-chlorat; Kupfer (II)-chlorid; Kupfer (II)-fluorosilicat; Kupfer (II)-formiat; Kupfer (II)-selenat; und/oder Kupfer (II)-sulfat und Resorcin, ausgewählt ist.

13. Lösung nach einem der Ansprüche 11 oder 12, umfassend einen zweiten Korrosionsinhibitor, wobei der zweite Korrosionsinhibitor von dem ersten Korrosionsinhibitor unterschiedlich ist und aus der Gruppe, bestehend aus Resorcin, Glycerol, Sorbitol und Kupfer (II)-nitrat, ausgewählt ist.

14. Lösung nach den vorhergehenden Ansprüchen, wobei der Gefrierpunkt unter -15 Grad Celsius oder unter -21 Grad Celsius liegt.

15. Verfahren von Abreinigen von Lack von einem Substrat umfassend:
Inkontaktbringen des Lacks auf einem Substrat mit einer Entfernerlösung für eine Zeit,
die zum Entfernen der gewünschten Menge an Lack ausreichend ist, und Entfernen des Substrats von der Entfernerlösung, wobei die Entfernerlösung umfasst:
20 Gew.-% bis 90 Gew.-% Dimethylsulfoxid;
1 Gew.-% bis 7 Gew.-% quartäres Ammoniumhydroxid;
1 Gew.-% bis 75 Gew.-% Alkanolamin;
0,001 Gew.-% bis 7 Gew.-% von einem oder mehr Korrosionsinhibitoren; und
1 Gew.-% bis 8 Gew.-% Wasser;
wobei die Lösung einen Gefrierpunkt von unter 0 Grad Celsius aufweist;
wobei das Alkanolamin mindestens zwei Kohlenstoffatome, mindestens einen Aminosubstituenten und mindestens einen Hydroxylsubstituenten aufweist, wobei die Amino- und Hydroxylsubstituenten an zwei unterschiedlichen Kohlenstoffatomen gebunden sind;
und
wobei das quartäre Ammoniumhydroxid im Wesentlichen frei von Tetramethylammoniumhydroxid ist und Cholinhydroxid einschließt.

## Revendications

1. Solution de décapage permettant d'éliminer une photorésine de substrats comprenant :
de 20 % en poids à 90 % en poids de diméthylsulfoxyde ;
de 1 % en poids à 7 % en poids d'hydroxyde d'ammonium quaternaire ;
de 1 % en poids à 75 % en poids d'alcanolamine ;
de 0,001 % en poids à 7 % en poids d'un ou plusieurs inhibiteurs de corrosion ; et
de l'eau ;
la solution présentant un point de congélation inférieur à 0 degré Celsius ;
dans laquelle l'alcanolamine comporte au moins deux atomes de carbone, au moins un substituant amino et au moins un substituant hydroxyle, les substituants amino et hydroxyle étant fixés à deux différents atomes de carbone,
et
dans laquelle l'hydroxyde d'ammonium quaternaire est essentiellement exempt d'hydroxyde de tétraméthylammonium et inclut de l'hydroxyde de choline.

2. Solution selon la revendication 1, comprenant de 1 % en poids à 8 % en poids d'eau ou dans laquelle un rapport de la quantité d'eau à la quantité de l'hydroxyde d'ammonium quaternaire est supérieur à 1,2.

3. Solution selon les revendications précédentes, dans laquelle l'alcanolamine est présente dans une quantité de 25 % en poids à 75 % en poids.

4. Solution selon les revendications précédentes, dans laquelle l'alcanolamine inclut de la monoéthanolamine.

5. Solution selon les revendications précédentes, dans laquelle le diméthylsulfoxyde est présent dans une quantité de 55 % en poids à 60 % en poids ;
dans laquelle l'hydroxyde d'ammonium quaternaire est présent dans une quantité de 1,5 % en poids à 3,5 % en poids ;
dans laquelle l'alcanolamine est présente dans une quantité de 30 % en poids à 40 % en poids ; et
dans laquelle les inhibiteurs de corrosion sont présents dans une quantité de 0,001 % en poids à 3 % en poids.

6. Solution selon les revendications précédentes, dans laquelle un premier inhibiteur de corrosion est sélectionné dans le groupe constitué du résorcinol, du glycérol, du sorbitol, et du nitrate de cuivre (II).

7. Solution selon les revendications précédentes 1 à 5, dans laquelle un premier inhibiteur de corrosion est sélectionné dans le groupe constitué du nitrate de cuivre (II) ; du bromure de cuivre (II) ; du chlorate de cuivre (II) ; du chlorure de cuivre (II) ; du fluorosilicate de cuivre (II) ; du formiate de cuivre (II) ; du séléniate de cuivre (II) ; et/ou du sulfate de cuivre (II) et du résorcinol.

8. Solution selon les revendications précédentes, dans laquelle un premier inhibiteur de corrosion est présent dans une quantité comprise entre 0,001 % en poids et 0,1 % en poids.

9. Solution selon les revendications précédentes, comprenant en outre de 0,01 % en poids à 3 % en poids de tensioactif.

10. Solution selon les revendications 6 à 8, comprenant un deuxième inhibiteur de corrosion, dans laquelle le deuxième inhibiteur de corrosion est différent du premier inhibiteur de corrosion et est sélectionné dans le groupe constitué du résorcinol, du glycérol, du sorbitol, et du nitrate de cuivre (II).

11. Solution selon les revendications précédentes 1 à 4, dans laquelle le diméthylsulfoxyde est présent dans une quantité de 35 % en poids à 45 % en poids, l'hydroxyde d'ammonium quaternaire est présent dans une quantité de 1,5 % en poids à 3,5 % en poids, l'alcanolamine est présente dans une quantité de 50 % en poids à 60 % en poids, un premier inhibiteur de corrosion est présent dans une quantité de 0,05 % en poids à 3 % en poids, et un deuxième inhibiteur de corrosion dans une quantité de 0,001 % en poids à 0,1 % en poids.

12. Solution selon la revendication 11, dans laquelle un premier inhibiteur de corrosion est sélectionné dans le groupe constitué du nitrate de cuivre (II) ; du bromure de cuivre (II) ; du chlorate de cuivre (II) ; du chlorure de cuivre (II) ; du fluorosilicate de cuivre (II) ; du formiate de cuivre (II) ; du séléniate de cuivre (II) ; et/ou du sulfate de cuivre (II) et du résorcinol.

13. Solution selon l'une quelconque des revendications 11 ou 12, comprenant un deuxième inhibiteur de corrosion, dans laquelle le deuxième inhibiteur de corrosion est différent du premier inhibiteur de corrosion et est sélectionné dans le groupe constitué du résorcinol, du glycérol, du sorbitol, et du nitrate de cuivre (II).

14. Solution selon les revendications précédentes, dans laquelle le point de congélation est inférieur à - 15 degrés Celsius ou inférieur à -21 degrés Celsius.

15. Procédé d'élimination d'une résine photosensible d'un substrat comprenant :
la mise en contact de la résine photosensible sur un substrat avec une solution de décapage pendant suffisamment de temps pour éliminer la quantité souhaitée de résine photosensible et le retrait du substrat de la solution de décapage, dans lequel la solution de décapage comprend :
de 20 % en poids à 90 % en poids de diméthylsulfoxyde ;
de 1 % en poids à 7 % en poids d'hydroxyde d'ammonium quaternaire ;
de 1 % en poids à 75 % en poids d'alcanolamine ;
de 0,001 % en poids à 7 % en poids d'un ou plusieurs inhibiteurs de corrosion ; et
1 % en poids à 8 % en poids d'eau ;
dans lequel la solution présente un point de congélation inférieur à 0 degré Celsius ;
dans lequel l'alcanolamine comporte au moins deux atomes de carbone, au moins un substituant amino et au moins un substituant hydroxyle, les substituants amino et hydroxyle étant fixés à deux différents atomes de carbone ; et
dans lequel l'hydroxyde d'ammonium quaternaire est essentiellement exempt d'hydroxyde de tétraméthylammonium et inclut de l'hydroxyde de choline.
